# EUROPÄISCHE PATENTSCHRIFT

(11) **EP 1 482 563 B1**
(45) Veröffentlichungstag und Bekanntmachung des Hinweises auf die Patenterteilung: **28.05.2008**
(21) Anmeldenummer: 04090201.7
(22) Anmeldetag: 18.05.2004
(51) Int. Cl.: H01L 31/0203, H01L 31/0216

(54) **Transparentes Versiegelungsmaterial für lichtbestrahlte, photoelektronisch aktive Oberflächen, Verfahren zur Herstellung und Anwendung**
Transparent sealing material for photoelectrically active surfaces, method of production and related use
Matériau d'étanchéité transparent pour surfaces photoélectriques, procédé de fabrication et application correspondante

(30) Priorität: 31.05.2003 DE 10325149
(43) Veröffentlichungstag der Anmeldung: 01.12.2004
(73) Patentinhaber: Hahn-Meitner-Institut Berlin GmbH, 14109 Berlin (DE)
(72) Erfinder: Tributsch, Helmut, 14109 Berlin (DE); Rojas-Chapana, Jose, 53113 Bonn (DE); Küppers, Udo, 28213 Bremen (DE)
(74) Vertreter: Rudolph, Margit

(56) Entgegenhaltungen:
- EP-A- 1 058 320
- EP-A- 1 202 609
- US-A- 6 130 448
- KURKLU A ET AL: "Thermal performance of a water-phase change material solar collector" RENEWABLE ENERGY, PERGAMON PRESS, OXFORD, GB, Bd. 26, Nr. 3, Juli 2002 (2002-07), Seiten 391-399, XP004335604 ISSN: 0960-1481

## Beschreibung

Die Erfindung bezieht sich auf ein transparentes Versiegelungsmaterial für lichtbestrahlte, photoelektronisch aktive Oberflächen mit einer chemischen Zusammensetzung aus einer transparenten organischen Basiskomponente und mehreren zugesetzten Additiven zur Verbesserung der Langzeitstabilität des Versiegelungsmaterials und auf ein Verfahren zur Herstellung und Anwendung.

Derartige transparente Versiegelungsmaterialien dienen dem Schutz von technischen Oberflächen mit photoelektronisch aktiven Funktionen und werden bestimmungsgemäß besonders starker Lichteinstrahlung, aber auch anderen naturkorrodierenden Witterungseinflüssen ausgesetzt. Neben der Lichteinstrahlung selbst, die insbesondere durch schwankende Erwärmung und Umsetzung einzelner Materialkomponenten starke Alterungserscheinungen hervorruft, sind es der Regen und der Wind, die die Versiegelungsmaterialien durch Feuchtigkeit, "Sandstrahlen" und Salzablagerungen besonders belasten. Bei den schützenden Oberflächenversiegelungen kann es sich beispielsweise um besonders harte, anorganische Oxidschichten oder um organische Versiegelungsschichten handeln, wobei die letzteren jedoch in der Regel nicht die geforderte Dauerstandfestigkeit aufweisen.

Aus der DE 37 25 338 A1 ist es bekannt, ein photovoltaisches Element mit einer Verkapselung der Oberfläche aus kristallinem oder amorphem Kohlenstoff als Versiegelungsmaterial zu versehen. In der DE 102 31 428 A1 wird eine wetterfeste Versiegelung eines zwischen zwei Flachgläsern angeordneten Solarzellenmoduls durch ein Umschließen der einzelnen Solarzelle mit einem wetterfesten und transparenten Harzfilm aus Polyethylenterephtalat (PET) oder einem fluorbasierten Harzfilm beschrieben. Aus der **Veröffentlichung I** von A.K. Plessing et al.: "Progress and Performance of new encapsulating Materials" (16th European Photovoltaic Solar Energy Conference, 1-5 May 2000, Glasgow, UK) ist eine Einkapselungsschicht mit einer integrierten Feuchtigkeitsbarriere in Form einer dielektrischen Oxidschicht bekannt. Aus der EP 0 939 441 A2, von der die vorliegende Erfindung als nächstliegendem Stand der Technik ausgeht, ist es weiterhin bekannt, Solarzellen verschiedenen Typs mit photoelektronisch aktiven Oberflächen mit einem transparenten organischen Harz als Basiskomponente einzukapseln, dem mehrere Additive zur Verbesserung seiner Eigenschaften, insbesondere der Hitze-, Licht- und Wetterbeständigkeit zugesetzt sind. Bei dem organischen Harz auf der Basis von Polyolefinen handelt es sich bevorzugt um ein Kunstharz aus der Vinyl-Polymerisation, wie Polyvinyl-Butyral (PVB) oder Ethylen-Vinyl-Acetat (EVA), einsetzbar sind aber auch Urethan-, Silikon- oder Fluorharze. Die zugesetzten Additive dienen der Vernetzung des Harzes, dessen Lichtstabilisierung, der Absorption von UV-Strahlung, der Adhäsionsverbesserung und der Antioxidation. Alle Additive weisen zusammen einen Gewichtsanteil von maximal 5% des Harzgewichtes auf. Sie sind polarisiert ausgebildet, sodass durch Anlegen eines elektrischen Feldes ein Verteilungsgradient über die Schichtdicke des Harzes erreicht wird. Derartige Aus- und Weiterbildungen von Kunstharzen mit verschiedenen Additiven sind Gegenstand einer Reihe von Veröffentlichungen, die sich mit der Problematik der Dauerstandfestigkeit derartig naturkorrosionsgefährdeter Oberflächenbeschichtungen beschäftigen. Derartige organische, transparente Kunstharze, die keinen festen Schmelzpunkt aufweisen und relativ kostenintensiv in der Herstellung und Verarbeitung sind, leiden aber stark darunter, dass insbesondere Schäden durch UV-Lichteinstrahlung auftreten und das Material langsam degradiert und brüchig wird. Auch die bekannten chemischen Additive bieten hier keine befriedigende Abhilfe. Durch diese zerstörenden Alterungserscheinungen verliert die Versiegelung an Transparenz und wird feuchtedurchlässig, sodass die geforderte Schutzwirkung nicht mehr gegeben ist und die Langzeitstabilität deutlich gesenkt wird.

Das Dokument EP-A-1 058 320 beschreibt ein transparentes Verriegelungsmaterial für photoelektronisch aktive Oberflächen.

Die **Aufgabe** für die vorliegende Erfindung ist daher darin zu sehen, ein transparentes Versiegelungsmaterial der eingangs beschriebenen Art anzugeben, das eine langzeitstabile und kostengünstige Versiegelung starker Lichteinstrahlung ausgesetzter, photoelektronisch aktiver Oberflächen ermöglicht. Weiterhin soll ein kostengünstiges und einfaches Verfahren zur Herstellung eines solchen Versiegelungsmaterials angegeben werden, das sich auch auf bevorzugte Anwendungszwecke des Versiegelungsmaterials einfach anwenden lässt. Als **Lösung** für diese Aufgabe ist bei einem transparenten Versiegelungsmaterial der gattungsgemäßen Art vorgesehen, dass die transparente organische Basiskomponente ein langkettiges natürliches Wachs oder eine Wachsmischung mit einem oberhalb 70°C beginnenden Schmelztemperaturbereich ist, dem als Additive zumindest ein Antioxidanzium, ein Reduktionsmittel und ein Biozid zugesetzt sind. Vorteilhafte Ausführungsformen des erfindungsgemäßen Versiegelungsmaterials, Verfahren zur Herstellung und Anwendungen und vorteilhafte Weiterbildungen in den einzelnen Kategorien sind den nachfolgenden Ansprüchen zu entnehmen, die im Folgenden und im speziellen Beschreibungsteil im Zusammenhang mit der Erfindung näher erläutert werden.

Die vorliegende Erfindung stellt ein natürliches, wachsbasiertes Gemisch von Komponenten zur Verfügung, das längerfristig als photostabiles Versiegelungsmaterial für eine starker Lichteinstrahlung ausgesetzte, photoelektronisch aktive Oberfläche sowohl eine gute Transparenz als auch Stabilität und Resistenz gegen mikrobiellen Angriff gewährleistet. Dabei handelt es sich gleichzeitig um ein sehr preisgünstiges Versiegelungsmaterial, wodurch die Herstellungskosten entsprechend versiegelter Oberflächen resp. der zugehörigen Bauelemente deutlich gesenkt werden können, beispielsweise bei Solarzellen um rund ein Drittel. Die erzielbare Wirkung des erfindungsgemäßen Versiegelungsmaterials ist insbesondere in dessen spezieller Zusammensetzung auf Basis eines Naturwachses (oder einer Wachsmischung) und eines zugesetzten Biozids begründet. Das enthaltene organische Wachs, das im Gegensatz zu den bekannten Harzen einen festen Schmelzpunkt und damit klar definierte technische Eigenschaften aufweist, gewährleistet die Versiegelung einer technischen Oberfläche bei gleichzeitig völliger Transparenz für Licht zwischen 200 nm und 2 µm ohne auftretende Lichtabsorption. Durch den relativ hohen Schmelzpunkt wird ein vollständiges Wegschmelzen der wachsbasierten Versiegelungsschicht im Betriebsfall sicher verhindert. Wachse mit einem niedrigeren Schmelzpunkt, beispielsweise Bienenwachse, sind somit nicht geeignet. Weiterhin wirkt das wasserunlösliche Wachs als zuverlässige Dampfsperre und bietet somit eine Lösung für das Problem der Feuchtigkeitseinwirkung auf technische Oberflächen an. Das zugemischte Antioxidanzium reagiert mit Radikalen, die photochemisch erzeugt werden und fängt sie ab. Es bildet somit einen UV-Schutz gegen zerstörerische Radikalenbildung. Weiterhin wirkt es als Schutz gegen die Einstrahlung von Infrarot-Licht und verhindert somit übermäßige Aufheizung der Versiegelungsschicht. Außerdem verhindert es die Spaltung und Reaktion anderer Komponenten mit Fremdkomponenten, sodass eine Schmutzablagerung auf der Oberfläche erschwert wird. Das Reduktionsmittel gibt Elektronen ab und trägt auf diese Weise auch zur Stabilität photochemischer Systeme bei. Es wirkt also rein als elektronenabgebende Substanz. Biozide wirken bakterizid, antiviral und fungizid und können somit verhindern, dass das wachsbasierte Versiegelungsmaterial biologisch angegriffen oder abgebaut wird. Insbesondere bei Feuchtigkeitseinfluss unter schlechter Belüftung ist die Abwehr von Schimmelpilzbildung besonders wichtig. Auch ein Abbau durch wachsfressende Tiere, beispielsweise Wespen, muss verhindert werden. Ohne einen solchen abwehrenden Zusatz kann ein natürliches Wachs nicht erfolgreich als langfristig wirkendes Versiegelungsmaterial eingesetzt werden. Dabei sollen unter dem verwendeten Begriff "Biozid" nicht nur abtötende, sondern auch abwehrende und neutralisierende Abwehrstoffe verstanden werden, die keine unbedingt abtötende Wirkung haben.

Technische Wachse sind aus dem Stand der Technik für unterschiedliche Anwendungen auf photoinaktiven Oberflächen allgemein bekannt. Hierbei handelt es sich jedoch in der Regel um synthetische Wachskomponenten, beispielsweise durch Raffinierung gewonnene Paraffinwachse, die grundsätzlich nicht für photochemisch aktive Oberflächen und deren spezielle Belange konzipiert sind. Derartige Wachse haben somit keine speziellen Zumischungen zur Abwehr von biologischen Angriffen und sind photoinstabil. Sie weisen eine völlig andere Zusammensetzungschemie auf und dienen in der Regel der reinen Konservierung einer passiven Oberfläche sowie der Erzeugung eines Glanzeffektes durch Polieren. Die reflektierenden Eigenschaften einer polierten Oberfläche sind aber insbesondere für eine photoelektronisch aktive Oberfläche, die auf die Lichtabsorption angewiesen ist, nicht brauchbar. Konservierende Glanzwachse unterliegen einem starken Verschleiß, insbesondere werden sie durch Lichteinstrahlung zersetzt und verunreinigen schnell, sodass sie in regelmäßigen, relativ kurzen Zeitabständen, beispielsweise schon nach ein bis zwei Jahren, erneuert werden müssen. Weiterhin werden Wachse in der Tintendrucktechnik und als wärmeabführendes Puffermaterial in Solarmodulen (vergleiche **Veröffentlichung II** : "Technical support package on combined photovoltaic and thermal-storage Module", J.W. Stultz, NASA Tech. Brief Vol. 5, No.3, Item No.24, Jet Propulsion Laboratory, Oktober 1983) verwendet. Eine Anwendung von natürlichen Wachsen zum Schutz von photochemisch aktiven Oberflächen ist bislang aus dem Stand der Technik nicht bekannt. Auch die Hinweise auf eine mögliche Verwendung, wie sie in der **Veröffentlichung III** "Bionik solarer Energiesysteme als Orientierungshilfe für Forschung und Technologieentwicklung" (H. Tributsch, FVS Themen 2000, Oktober 2000, pp123-130) und auf der **Internetseite** des Hahn-Meitner-Instituts (abrufbar unter http://www.hmi.de/bereiche/SE/ SE5/arbeitsg/3neue_energie.html.print, Stand 23.04.2003) zu finden sind, liefern keinen der Erfindung näherliegenden Stand der Technik als den oben zitierten mit einem gattungsbildenden transparenten Versiegelungsmaterial auf organischer Basis, da keine weiterführenden Angaben über die spezielle Zusammensetzung des wachsbasierten Gemisches gemacht werden. Es wird hier lediglich theoretisch eine Wachsverpackung von Solarzellen als mögliche Zukunftstechnologie erwähnt respektive zunächst die Frage gestellt, ob überhaupt eine Übertragung von schützenden, dünnen Wachsschichten auf die Technik von Solarzellen möglich ist. Diese Hinweise aus dem Stand der Technik gelangen daher nicht über eine theoretische Idee hinaus und geben dem Fachmann keine nachvollziehbare Lehre zum technischen Handeln an, insbesondere fehlt es an Angaben über die erforderlichen Modifikationen von Wachsen.

Im Gegensatz dazu zeigt die Erfindung die Zusammensetzung der nötigen Komponenten auf, die zur Lösung der gestellten Aufgabe erforderlich ist. Diese Zusammensetzung wird in den Unteransprüchen weiter spezifiziert. Zunächst handelt es sich dabei um die Angabe der Gewichtsanteile der einzelnen Komponenten in der chemischen Zusammensetzung. Gemäß einer ersten Ausführungsform der Erfindung ist ein Gewichtsanteil des natürlichen Wachses im Bereich von 60%, des Antioxidanziums im Bereich von 20%, des Reduktionsmittels im Bereich von 10% und des Biozids im Bereich von 10% an der chemischen Zusammensetzung vorteilhaft. In Laborversuchen bei der Anmelderin haben sich hier optimale Ergebnisse mit hoher Dauerstandfestigkeit, insbesondere auch unter den extremen Bedingungen des für Solarzellen üblichen "Damp-Heat-Tests", gezeigt. Allgemeines Grundlagenwissen über natürliche Wachse ist beispielsweise der **Veröffentlichung IV** "Waxes" (Ullmann's Encyclopedia of Industrial Chemistry, 1996, VCH Verlagsgesellschaft, Vol. A 28, pp 103-122, Kapitel 1 und 2) zu entnehmen. Gemäß einer nächsten Ausführungsform ist das transparente Versiegelungsmaterial gekennzeichnet durch einen Gewichtsanteil im Bereich von 40% von Esthern langkettiger, aliphatischer Alkohole und Säuren und im Bereich von 20% von Oligoesthern mit zwei oder mehr Estherfunktionen als Komponenten des Wachses an der chemischen Zusammensetzung. Hierbei handelt es sich dann um einen typischen Wachs, wie er in der Natur vorkommt. Bevorzugt zeigen solche natürlichen Wachse eine Kettenlänge zwischen 16 und 36 Kohlenstoffatomen. Bei der Erfindung werden Kettenlängen zwischen 22 und 36 Kohlenstoffatomen, insbesondere 30 Kohlenstoffatome, bevorzugt. Dabei kann die Kettenlänge variabel sein und es können Gemische unterschiedlicher Kettenlängen im Wachs auftreten.

Neben dem natürlichen Wachs, das mit ungefähr 60% den größten Gewichtsanteil und damit die Basis stellt, weshalb bei der Erfindung von einem "wachsbasierten Versiegelungsmaterial" gesprochen werden kann, bildet das Antioxidanzium mit einem Gewichtsanteil von ungefähr 20% den zweitgrößten Anteil. Bevorzugt kann hier das Versiegelungsmaterial nach der Erfindung durch einen Gewichtsanteil im Bereich bis 5% von aromatischen Säuren und Estern und im Bereich zwischen 1 % und 20% von aliphatischen Säuren als einzelne oder verbundene Komponenten des Antioxidanziums an der chemischen Zusammensetzung gekennzeichnet sein. Dabei kann es sich beispielsweise um Folsäure oder Folsäureesther handeln. Deren Verbindung mit einer aliphatischen Säure ergibt beispielsweise die Ferolsäure, die ein besonders wirksames Antioxidanzium darstellt. Weiterhin wird bevorzugt ein Alkohol als Reduktionsmittel eingesetzt, wobei dessen Gewichtsanteil an der chemischen Zusammensetzung in einem Bereich zwischen 5% und 15% liegt. Hierbei kann es sich beispielsweise um einen höherwertigen, langkettigen Cerylalkohol handeln. Bei einem Anstieg des Alkoholanteils auf 15%, reduzieren sich die Anteile der anderen Komponenten entsprechend. Schließlich können als Biozid noch Terpene, beispielsweise Triterpene, an der chemischen Zusammensetzung mit einem Gewichtsanteil in einem Bereich zwischen 1 % und 10% beteiligt sein.

Eine Verbesserung der Eigenschaften des photoelektronisch aktiven und photochemisch wiederstandsfähigen Versiegelungsmaterials nach der Erfindung kann noch durch weitere Zusätze oder Maßnahmen erreicht werden. Bevorzugt kann eine Beimischung von Nanopartikeln erfolgen, die nicht photoaktiv wirken, da es sonst zum Beispiel mit Titandioxid zu einer Bildung von Kohlendioxid kommen würde. Es kann beispielsweise eine Beimischung von abriebfesten Nanopartikeln in die gelöste Wachsmischung erfolgen, die die mechanische Stabilität des Versiegelungsmaterials nach der Erfindung verbessert und Abrasion durch Witterungseinflüsse an der Oberfläche wirksam verhindert. Ein Auftrag von Nanopartikeln aus einer Kolloidlösung heraus auf die ausgehärtete wachsbasierte Versiegelungsschicht ist ebenfalls möglich. Dies kann nachträglich auf die fertiggestellte wachsbasierte Versiegelungsschicht oder bevorzugt alternierend mit dem Aufbringen und Aushärten der einzelnen Versiegelungsschichten erfolgen. In letzterem Falle entsteht ein alternierender Schichtaufbau aus mehreren sich abwechselnden Schichten aus Versiegelungsmaterial und Nanopartikeln, der eine optimale Festigkeit der gesamten Struktur gewährleistet. Durch die Beimischung oder das Auftragen von Silikat-Nanoteilchen beispielsweise wird neben einer Abhärtung auch eine Verglasung des Versiegelungsmaterials erreicht, wodurch die Dauerstandfestigkeit einer erzeugten Beschichtung noch verbessert werden kann. Nanopartikel aus refraktiven Metalloxiden sind ebenfalls besonders hart und damit gut einsetzbar. Desweiteren kann vorteilhaft eine Beimischung von im Infrarotbereich reflektierenden Nanopartikeln erfolgen. Hierbei kann es sich beispielsweise um Nanocluster aus Silber handeln. Durch eine verstärkte Reflexion im Infrarotbereich wird eine übermäßige Aufheizung des Versiegelungsmaterials unter Lichteinstrahlung wirksam vermieden. Durch eine gesteuerte Zugabe von reflektiv wirkenden Nanoteilchen kann der Reflexionsgrad der Oberfläche entsprechend gesteuert eingestellt werden. Weiterhin ist eine Beimischung von biozid wirkenden Nanopartikeln möglich. Hierbei kann es sich beispielsweise um Titan- oder Zinkdioxid handeln, deren hohe antibakterielle Wirksamkeit allgemein bekannt ist. Derartige Komponenten können beispielsweise einem raffinierten Paraffin, wie es im Stand der Technik zu Konservierungszwecken eingesetzt wird, nicht zugemischt werden, da sie hier zu einer Zersetzung und damit Zerstörung des Wachses führen würden. Auch aus diesem Grund können technische Wachse nicht zum Schutz von photoelektronisch aktiven Oberflächen eingesetzt werden. Natürliche Wachse zeigen sich hingegen gegenüber derartigen Beimischungen resistent.

Weiterhin kann das Versiegelungsmaterial nach der Erfindung noch eine Beimischung oder einen Auftrag von Barrierematerial aufweisen, das als funktionelle Schicht beispielsweise spezielle elektronische, thermische oder dampfabweisende Eigenschaften aufweist. Schließlich kann noch die Oberfläche des Versiegelungsmaterials gegen Verschmutzung geschützt werden, wenn nach einer nächsten Ausführungsform der Erfindung eine mechanisch, chemisch, elektrisch oder optisch hervorgerufene Mikrostrukturierung in der Oberfläche vorgesehen ist. Durch Anwendung einer mikrostrukturierten Oberfläche, die kaum Angriffspunkte zur Anheftung von Schmutzpartikeln bietet, kann eine Verschmutzung vermieden oder zumindest durch einfaches Abwaschen schnell behoben werden, was für die Funktion der lichtaktiven Oberfläche von ausschlaggebender Bedeutung ist. Die Strukturierung zur Erzeugung solcher Selbstreinigungseffekte kann beispielsweise durch einfaches Prägen, Kratzen oder Ätzen erzeugt werden.

Ein wesentlicher Vorteil des Versiegelungsmaterials nach der Erfindung ist auch in seiner Herstellung zu sehen. Diese läuft völlig unkompliziert bei Raumtemperatur durch eine einfache chemische Zusammenführung eines langkettigen natürlichen Wachses oder einer Wachsmischung mit einem oberhalb 70°C beginnenden Schmelztemperaturbereich als transparente organische Basiskomponente mit zumindest einem Antioxidanzium, einem Reduktionsmittel und einem Biozid als Additive zur Verbesserung der Langzeitstabilität des Versiegelungsmaterials ab, wobei die Gesamtheit der zusammenzuführenden Komponenten von den Anforderungen an das Versiegelungsmaterial abhängen. Bevorzugt können als weitere Additive abriebfeste und/oder im Infrarotbereich reflektierende und/oder biozid wirkende Nanopartikel beigemischt oder nachträglich aufgebracht werden, die photoinaktiv sind und die photoelektronischen Reaktionen in der funktionellen Oberfläche nicht beeinflussen. Besonders einfach und preisgünstig wird das Herstellungsverfahren, wenn die Wachsbasis aus speziellen Pflanzenhüllen gewonnen wird. Somit kann bevorzugt eine Gewinnung des natürlichen Wachses durch Auflösung des zerkleinerten Wachsmantels spezieller, einen Wachsmantel aufweisenden Pflanzen in einem Lösungsmittel und Abfiltrieren des gelösten Wachses nach einer vorgegebenen Standzeit erfolgen. Bei der Pflanze für die Wachsgewinnung kann es sich bevorzugt um *Sarcocaulon Patersonii* handeln, eine Geranienart, die hauptsächlich im südwestlichen Afrika vorkommt. Somit ist diese Pflanze extremen Witterungsbedingungen, insbesondere starker Lichteinstrahlung und Abrasion durch Sandstrahlen, unterworfen und ihr schützender Wachsmantel eignet sich in besonderer Weise als Basis für die Versiegelungsschicht nach der Erfindung. Gleiches gilt für das Wachs der in Mexiko beheimateten Pflanze *Euphorbia Cerifera,* das als Candelillawachs bekannt ist und insbesondere im Kosmetik- und Pharmazeutikbereich eingesetzt wird. Das extrahierte Wachs kann dann weiter aufbereitet und beispielsweise mit Nanoteilchen versetzt werden. Aber auch viele andere, für die Wachsgewinnung geeignete Pflanzen haben dünnere oder dickere Wachsmäntel, die speziellen klimatischen Bedingungen und Ansprüchen der Pflanzen angepasst sind. Sie müssen sich gegen Wasserverlust, UV-Strahlung und mikrobiologische Angriffe schützen.

Eine geeignete Wachsbasis kann aus dem Wachsmantel der Geranienart folgendermaßen gewonnen werden. Der Wachsmantel abgestorbener Pflanzen von *Sarcocaulon Patersonii* wird zerkleinert und in einer ungefähren Konzentration von 100 Gramm pro Liter einem Lösungsmittel, bevorzugt Dichlormethanlösung, zugesetzt. Die Mischung wird bei Raumtemperatur ungefähr eine Woche so belassen. Durch diese passive Extraktion werden circa 20% des Wachsmantels gelöst, der Rest wird abfiltriert. Die gewonnene, leicht gelbfarbige Lösung dient dann als Ausgangslösung für den Zusatz der weiteren erforderlichen Komponenten und anschließend für die Aufbringung des Versiegelungsmaterials auf die zu schützende Oberfläche. Eine dünne Versiegelungsschicht kann bevorzugt beispielsweise durch zyklisches Eintauchen einer zu versiegelnden photoreaktiven Oberfläche in die abfiltrierte Wachslösung als Tauchlösung bei Raumtemperatur und Aushärten der einzelnen wachsbasierten Versiegelungsschichten durch Entfernen des Lösungsmittels bis zur Erreichung einer vorgegebenen Gesamtschichtstärke abgeschieden werden. Dieser einfache Tauchvorgang kann beispielsweise über eine einfache mechanische Taucheinrichtung realisiert werden. Durch die Anzahl der Tauchgänge, die zyklisch mit Aushärtungsphasen und/oder Schichten aus Nanoteilchen abgewechselt werden können, kann die Schichtdicke und die Einlagerung von Nanoteilchen variiert und den Langzeitbedingungen angepasst werden. Hier gilt, dass dickere Schichten mit einem homogenen Nantoteilchengehalt eine größere Dauerstandfestigkeit aufweisen, sodass eine Lebensdauer im Bereich der Lebensdauer des zu versiegelnden Elements, beispielsweise über 10 bis 15 Jahre, erreicht und die Notwendigkeit erneuter Beschichtungen verhindert werden können. Dabei können die Aushärtungsphasen mit oder ohne zusätzliche Wärmezufuhr ablaufen. Eine ungefähr 50 µm bis 100 µm dicke Schicht zeigt praktisch keine Absorption für sichtbares Licht und im nahen UV-Bereich (zwischen 200 nm und 2 µm Wellenlänge). Als weitere mögliche Beschichtungsverfahren sind das Aufsprühen oder Aufpinseln zu nennen. Auch hierbei handelt es sich um besonders einfache Verfahren, die bei Raumtemperatur durchgeführt werden können. Fertiggestellte Schichtenpakete können dann noch auf ihrer Oberfläche mikrostrukturiert werden, um beispielsweise Schmutzablagerungen zu verhindern.

Aus dem Stand der Technik sind viele Anwendungen für wachsbasierte Versiegelungsmaterialien für photoelektrisch inaktive Oberflächen bekannt. Neu ist deren Anwendung in modifizierter Form auf photoelektronisch aktive Oberflächen, da diese besonders intensiver Langzeitbestrahlung ausgesetzt werden Eine besonders vorteilhafte Anwendung eines transparenten Versiegelungsmaterial für starker Lichteinstrahlung ausgesetzte technische Oberflächen mit einer chemischen Zusammensetzung aus einem langkettigen natürlichen Wachs oder einer Wachsmischung mit einem oberhalb 70°C beginnenden Schmelztemperaturbereich als transparente organische Basiskomponente und zumindest einem Antioxidanzium, einem Reduktionsmittel und einem Biozid als Additive zur Verbesserung der Langzeitstabilität des Versiegelungsmaterials ergibt sich deshalb in einer Ausbildung als Deckschicht oder als Zwischenschicht unter einer Abdeckscheibe in einem Photovoltaikelement. Insbesondere photovoltaische Elemente zeigen besonders deutlich die eingangs beschriebenen Probleme. Die Entwicklung geeigneter Versiegelungsmaterialien mit einer wirklich bedeutsamen Verbesserung der Langzeitstabilität ist hier seit Längerem Gegenstand intensiver Forschungen. Gleichzeitig wird aber auch nach kostengünstigen Lösungen gesucht. Die Erfindung bietet beides in befriedigender Weise. Das wachsbasierte Versiegelungsmaterial nach der Erfindung kann sowohl in bestehende, laminierte Solarmodulaufbauten, beispielsweise in einer Ausführungsform als Kupferindium-Solarzellen (CIS), als hochwirksame Zwischenschicht mit Barrierefunktion (Dampfsperre) einfach integriert werden als auch direkt die eigentliche Verkapselungsfunktion übernehmen und als Deck- oder Verkapselungsschicht ausgebildet sein. Somit kann bevorzugt eine Ausbildung als vollständige Einkapselung eines Photovoltaikelement vorgesehen sein. Ein solcher flexibler Aufbau ist dann mit asiatischen Lackwaren, die eine Vielzahl von übereinander liegenden, einzelnen Lackschichten aufweisen, vergleichbar. Durch den Wegfall einer schützenden Glasplatte ergibt sich eine wesentliche Gewichtsreduzierung in einem Bereich von 20% bis 50% des Modulgewichts und dessen vorteilhafte Flexibilisierung, sodass es einfach beliebigen Untergrundverläufen angepasst werden kann. Weiterhin sind dann völlig neue modulare Verbindungstechniken, beispielsweise durch einfache Klettverbindungen, und Fertigungstechniken realisierbar. Reparaturen durch erneutes Auftragen des wachsbasierten Versiegelungsmaterials nach der Erfindung sind ebenfalls einfach durchführbar.

Wegen der wasserabhaltenden, lichtdurchlässigen, photostabilen und antibakteriellen sowie fungiziden Eigenschaften des wachsbasierten Versiegelungsmaterials nach der Erfindung, das damit die naturkorrodierenden Mechanismen stark abbremsen kann, können auch Versiegelungsschichten für den Korrosionsschutz von Metallen oder für deren Einkapselung zur Vermeidung allergischer Hautreaktionen konzipiert werden. Weiterhin ist auch ein Einsatz bei wasserbenetzten Oberflächen, die trotzdem noch einem relativ starken Lichteinfluss ausgesetzt sind, möglich.

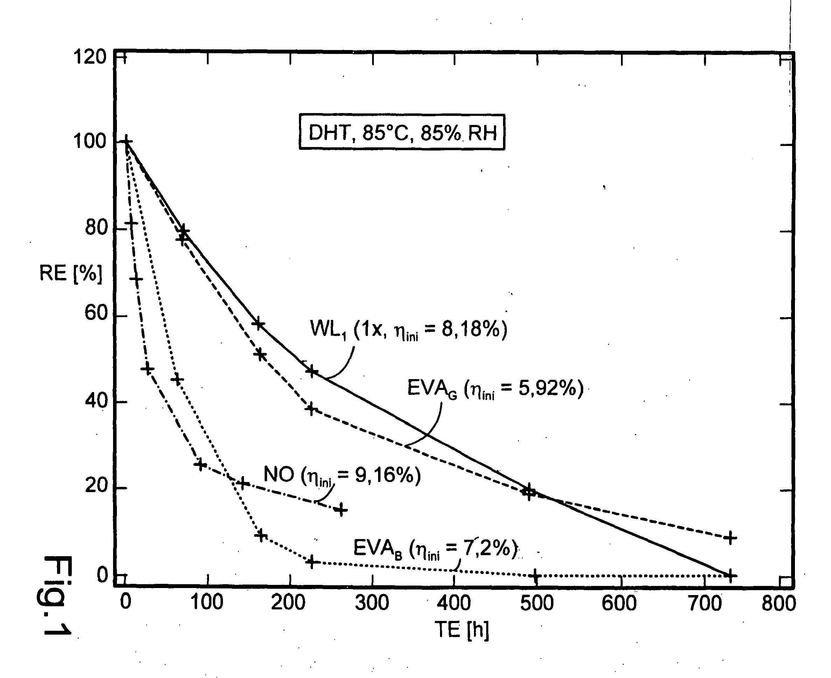

Die vorteilhaften Eigenschaften der Erfindung werden nachfolgend anhand von Diagrammen zu Klimatests von unterschiedlichen Proben in den **Figuren 1 bis 3** noch näher erläutert. Dabei zeigen die Diagramme die Ergebnisse der Haltbarkeit bzw. Beständigkeit von nach der Erfindung wachsversiegelten CulnS₂-Solarzellenproben gegenüber unverkapselten und mit EVA-glasverkapselten Solarzellenproben. Alle Tests wurden in einer Klimakammer bei 85°C und bei 85% relativer Luftfeuchtigkeit (**RH** 85%) durchgeführt. Dabei führt eine solche Temperatur nicht zur Aufschmelzung des wachsbasierten Versiegelungsmaterials nach der Erfindung, das einen oberhalb 70°C beginnenden Schmelztemperaturbereich aufweist. Durch die Mischung beginnt der Schmelzpunkt fließend und überstreicht kontinuierlich einen größeren Bereich. Im Damp-Heat-Test beginnt höchstens ein oberflächliches Anschmelzen einzelner Komponenten, die die Stabilität der gesamten Wachsversiegelungsschicht aber nicht beeinflusst. Aus der Solartechnik ist bekannt, dass auf den photoelektronisch aktiven Oberflächen Temperaturen in einem Bereich von 70°C herrschen können. Für diesen Anwendungsbereich weist das wachsbasierte Versiegelungsmaterial nach der Erfindung einen optimal eingestellten Schmelzbereich auf. Das Versiegelungsmaterial wurde jeweils auf Basis von *Sarcocaulon patersonii* hergestellt, wie es weiter oben bereits beschrieben wurde. Dabei weisen die Solarzellenproben nach der Erfindung unterschiedliche Schichtstärken des wachsbasierten Versiegelungsmaterials auf, die durch unterschiedliche Anzahlen von Tauchgängen erzeugt wurden.

Das Diagramm in der **Figur 1** zeigt die relative Effizienz **RE** in Prozent als Maß für die Initialwerterhaltung (hier anfänglicher Wirkungsgrad η) unterschiedlicher CulnS₂-Solarzellenproben in Abhängigkeit von der Standzeit **TE** in Stunden in einem Klimatest (Damp-Heat-Test **DHT)** unter Testbedingungen 85°C und 85 % **RH.** Die durchgezogene Kurve ergibt sich unter den herrschenden Bedingungen für eine Solarzellenprobe **WL₁** mit einer durch einmaliges Eintauchen (1x) in die Wachslösung hergestellten Wachsbeschichtung nach der Erfindung mit einem anfänglichen Wirkungsgrad ηᵢₙᵢ von 8,18 %. Die gepunktete Kurve ergibt sich für eine unverkapselte Solarzellenprobe **NO** (anfänglicher Wirkungsgrad ηᵢₙᵢ von 8,18 %), die gestrichelte Kurve gehört zu einer gut mit EVA und Glas verkapselten Solarzellenprobe **EVA_{G}** mit einem niedrigeren anfänglichem Wirkungsgrad ηᵢₙᵢ von 5,92 %. Die strichpunktierte Kurve zeigt den Effizienzverlust einer schlecht mit **EVA** und Glas verkapselten Solarzellenprobe **EVA_{B}** mit einem höheren anfänglichem Wirkungsgrad ηᵢₙᵢ von 7,20 %. In dem Diagramm ist deutlich zu erkennen, dass alle Solarzellenproben einen Effizienzverlust aufweisen. Es zeigt sich dabei, dass sowohl die gut verkapselte Solarzellenprobe **EVA_{G}** und die mit Wachs versiegelte Solarzellenprobe **WL₁** nach der Erfindung einen deutlich langsameren Effizienzverlust aufweisen als die unverkapselte Solarzellenprobe **NO** und die schlecht verkapselte Solarzellenprobe **EVA_{B},** die im Laufe der Zeit zerfallen und dadurch einen sehr großen Effizienzverlust aufweisen. Insgesamt zeigt die wachsversiegelte Solarzellenprobe **WL₁** nach der Erfindung die beste Dauerstandfestigkeit. Erst nach 500 h erreicht sie denselben Effizienzverlust wie die gut verkapselte Solarzellenprobe **EVA_{G}.** Somit weisen mit dem wachsbasierten Versiegelungsmaterial beschichtete Solarmodule ähnliche Stabilität und Haltbarkeit auf wie ein mit EVA-Glas aufwändig verkapseltes Solarmodul.

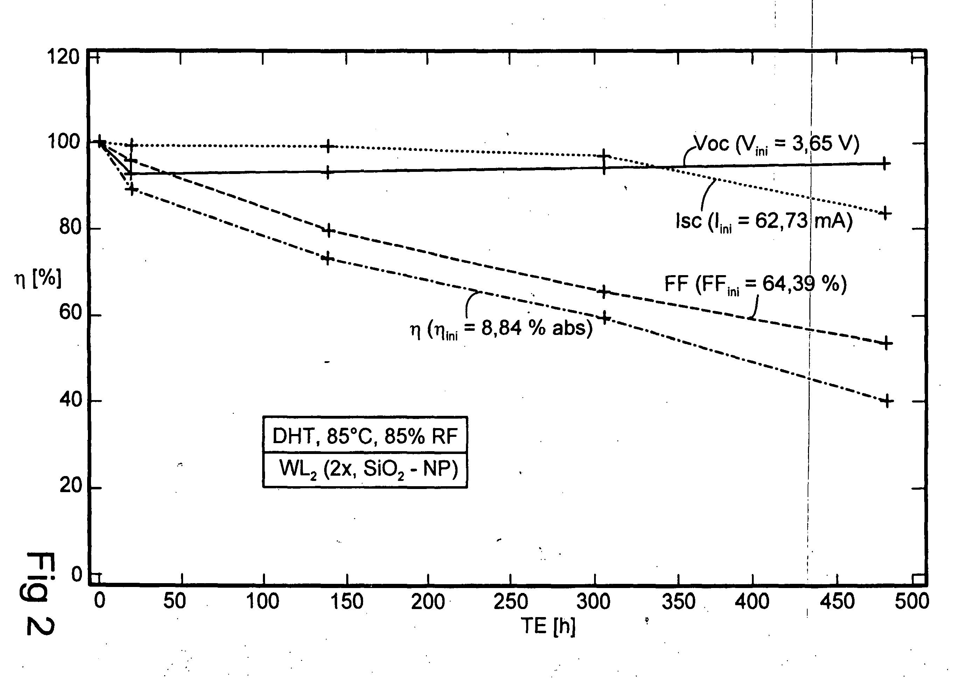

In dem Diagramm gemäß **Figur 2** ist der relative Wertverlust **VL** in Prozent für verschiedene charakteristische Parameter einer wachsversiegelten Solarzellenprobe **WL₂** nach der Erfindung über der Standzeit **TE** in Stunden dargestellt. Die Solarzellenprobe **WL₂** wurde zweimal (2x) mit einer Wachsschicht überzogen und anschließend mit SiO₂-Nanopartikeln **NP** (Levasil Bayer 200 S / 30 %) bei gleichem Verfahren (1 x Eintauchen) beschichtet, was einer direkten Zugabe von Nanopartikeln in die Wachslösung entspricht. Durch die zusätzliche Zugabe von Silika (SiO₂) -Nanopartikeln oder auch Al₂O₃, ZrO₂ und Ag-Nanopartikeln kann eine gesteigerte Langzeitstabilität der wachsbeschichteten Solarzellenproben erreicht werden. Bei den bezüglich ihrer Verschlechterung gemessenen Parametern handelt es sich um die offene Klemmenspannung **V_{oc}** (anfänglicher Wert **Vᵢₙᵢ** von 3,65 V, durchgezogene Kurve), den Kurzschlussstrom **I_{sc}** (anfänglicher Wert **Iᵢₙᵢ** von 62,73 mA, gepunktete Kurve), den Füllfaktor **FF** (anfänglicher Wert **FFᵢₙᵢ** von 64,39 %, gestrichelte Kurve) und den Wirkungsgrad η (anfänglicher Wert η**ᵢₙᵢ** von 8,84% absolut, strichpunktierte Kurve). Dabei ist der Füllfaktor **FF** das Maß dafür, wie gut eine Solarzelle in der Lage ist, die durch Licht erzeugten Ladungsträger zu sammeln. Aus dem Diagramm gemäß **Figur 2** ist gegenüber dem Diagramm gemäß **Figur 1** zu erkennen, dass durch eine Zugabe von Nanopartikeln **NP** der Effizienzverlust unterschiedlicher charakteristischer Parameter deutlich gesenkt werden kann. Nach ca. 475 Stunden wies die wachsversiegelte Si0₂-Probe **WL₂** den geringsten Effizienzverlust beim Wirkungsgrad η (ca. 60%) auf, der den für ein Solarmodul relevantesten und aussagekräftigsten Parameter bezüglich seiner Qualität darstellt.

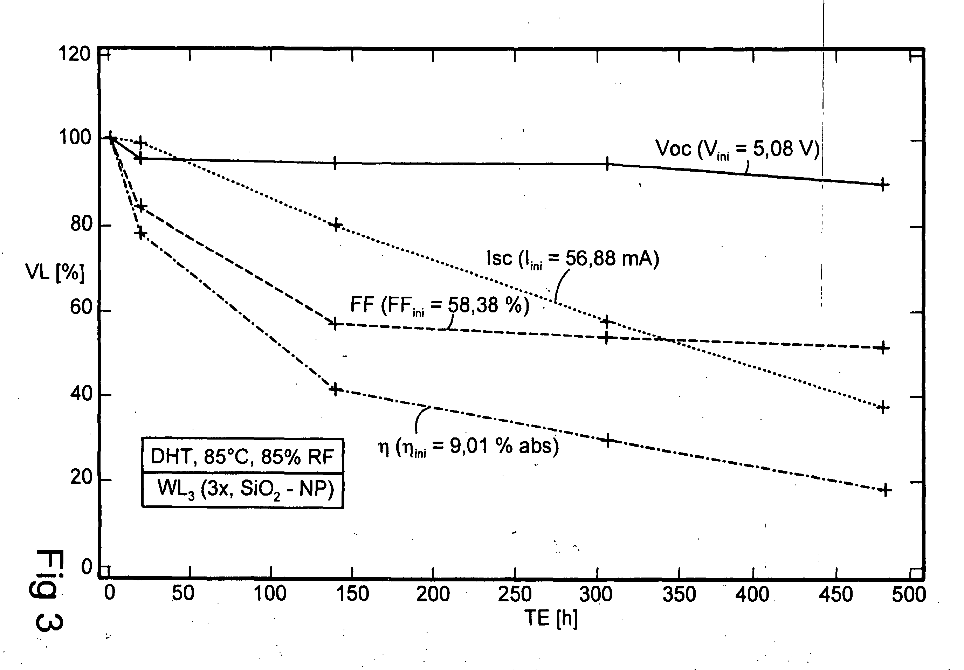

Das Diagramm gemäß **Figur 3** zeigt in Analogie zu dem Diagramm gemäß **Figur 2** eine Messung der charakteristischen Parameter für eine Solarzellenprobe **WL₃,** die dreimal mit Wachs beschichtet wurde (3x). Als Parameter sind wieder die offene Klemmenspannung **V_{oc}** (anfänglicher Wert **Vᵢₙᵢ** von 5,08 V, durchgezogene Kurve), der Kurzschlussstrom **l_{sc}** (anfänglicher Wert **Iᵢₙᵢ** von 56,88 mA, gepunktete Kurve), der Füllfaktor **FF** (anfänglicher Wert **FFᵢₙᵢ** von 64,39 %, gestrichelte Kurve) und der Wirkungsgrad η (anfänglicher Wert ηᵢₙᵢ von 8,84% absolut, strichpunktierte Kurve) gewählt. Insgesamt ist durch die dickere wachsbasierte Versiegelungsschicht deren Transparenz etwas vermindert, was sich in den gegenüber dem Diagramm gemäß **Figur 2** mit einer nur zweimal beschichteten Probe **WL₂** veränderten Parameterverläufen zeigt. Der Effizienzverlust ist aber gegenüber der Solarzellenprobe **WL₁** gemäß dem Diagramm aus **Figur 1** nach ca. 450 h ungefähr gleich und liegt bei 80%.

### Bezugszeichenliste für die Diagramme

- **DHT**: Damp-Heat-Test
- **EVA_{G}**: mit EVA und Glas gut verkapselte Solarzellenprobe
- **EVA_{B}**: mit EVA und Glas schlecht verkapselte Solarzellenprobe
- **FF**: Füllfaktor
- **ini**: anfänglicher Wert (Index)
- **I_{SC}**: Kurzschlussstrom
- **NO**: unverkapselte Solarzellenprobe
- **NP**: Nanopartikel
- **RE**: relative Effizienz
- **RH**: Luftfeuchtigkeit
- **TE**: Standzeit
- **WL₁**: wachsversiegelte Solarzellenprobe (1 x beschichtet)
- **WL₂**: wachsversiegelte Solarzellenprobe (2x beschichtet)
- **WL₃**: wachsversiegelte Solarzellenprobe (3x beschichtet)
- **V_{OC}**: offene Klemmenspannung
- η: Wirkungsgrad

## Patentansprüche

1. Transparentes Versiegelungsmaterial für lichtbestrahlte, photoelektronisch aktive Oberflächen mit einer chemischen Zusammensetzung aus einer transparenten organischen Basiskomponente und mehreren zugesetzten Additiven zur Verbesserung der Langzeitstabilität des Versiegelungsmaterials, **dadurch gekennzeichnet, daß** die transparente organische Basiskomponente ein langkettiges natürliches Wachs oder eine Wachsmischung mit einem oberhalb 70°C beginnenden Schmelztemperaturbereich ist, dem als Additive zumindest ein Antioxidanzium, ein Reduktionsmittel und ein Biozid zugesetzt sind.

2. Transparentes Versiegelungsmaterial nach Anspruch 1,
**gekennzeichnet durch**
einen Gewichtsanteil des natürlichen Wachses oder der Wachsmischung im Bereich von 60%, des Antioxidanziums im Bereich von 20%, des Reduktionsmittels im Bereich von 10% und des Biozids im Bereich von 10% an der chemischen Zusammensetzung.

3. Transparentes Versiegelungsmaterial nach Anspruch 1 oder 2,
**gekennzeichnet durch**
eine variierbare Kettenlänge des natürlichen Wachses oder der Wachsmischung im Bereich von 22 bis 36 Kohlenstoffatomen.

4. Transparentes Versiegelungsmaterial nach einem der Ansprüche 1 bis 3,
**gekennzeichnet durch**
einen Gewichtsanteil im Bereich von 40% von Esthern langkettiger, aliphatischer Alkohole und Säuren und im Bereich von 20% von Oligoesthern mit zwei oder mehr Estherfunktionen als Komponenten des Wachses oder der Wachsmischung an der chemischen Zusammensetzung.

5. Transparentes Versiegelungsmaterial nach einem der Ansprüche 1 bis 4,
**gekennzeichnet durch**
einen Gewichtsanteil im Bereich bis 5% von aromatischen Säuren und Estern und im Bereich zwischen 1% und 20% von aliphatischen Säuren als einzelne oder verbundene Komponenten des Antioxidanziums an der chemischen Zusammensetzung.

6. Transparentes Versiegelungsmaterial nach einem der Ansprüche 1 bis 5,
**gekennzeichnet durch**
einen Alkohol als Reduktionsmittel, wobei dessen Gewichtsanteil an der chemischen Zusammensetzung in einem Bereich zwischen 5% und 15% liegt.

7. Transparentes Versiegelungsmaterial nach einem der Ansprüche 1 bis 6,
**gekennzeichnet durch**
einen Gewichtsanteil in einem Bereich zwischen 1% und 10% von Terpenen als Biozid an der chemischen Zusammensetzung.

8. Transparentes Versiegelungsmaterial nach einem der Ansprüche 1 bis 7,
**gekennzeichnet durch**
eine Beimischung oder einen Auftrag von abriebfesten Nanopartikeln und/oder im Infrarotbereich reflektierenden Nanopartikeln und/oder biozid wirkenden Nanopartikeln als lichtinaktiven Additive in der chemischen Zusammensetzung.

9. Transparentes Versiegelungsmaterial nach einem der Ansprüche 1 bis 8,
**gekennzeichnet durch**
eine Beimischung oder einen Auftrag von Barrierematerial.

10. Transparentes Versiegelungsmaterial nach 8 oder 9,
**gekennzeichnet durch**
einen alternierenden Schichtaufbau aus mehreren Schichten aus Versiegelungsmaterial und Nanopartikeln und/oder Barrierematerial.

11. Transparentes Versiegelungsmaterial nach einem der Ansprüche 1 bis 10,
**gekennzeichnet durch**
eine mechanisch, chemisch, elektrisch oder optisch hervorgerufene Mikrostrukturierung in der Oberfläche.

12. Verfahren zur Herstellung und Anwendung eines transparenten Versiegelungsmaterials für starker Lichteinstrahlung ausgesetzte, photoelektronisch aktive Oberflächen einer chemischen Zusammenführung eines langkettigen natürlichen Wachses oder einer Wachsmischung mit einem oberhalb 70°C beginnenden Schmelztemperaturbereich als transparente organische Basiskomponente mit zumindest einem Antioxidanzium, einem Reduktionsmittel und einem Biozid als Additive zur Verbesserung der Langzeitstabilität des Versiegelungsmaterials, insbesondere nach einem der Ansprüche 1 bis 7, wobei das natürliche Wachs oder die Wachsmischung durch Auflösung des zerkleinerten Wachsmantels von speziellen, einen Wachsmantel aufweisenden Pflanzen in einem Lösungsmittel und Abfiltrieren des gelösten Wachses nach einer vorgegebenen Standzeit gewonnen wird.

13. Verfahren nach Anspruch 12,
**gekennzeichnet durch**
die Verwendung von *Sarcocaulon Patersonii* oder *Euphorbia Cerifera* als Pflanze für die Wachsgewinnung.

14. Verfahren nach Anspruch 12 oder 13,
**gekennzeichnet durch**
die Verwendung von Dichlormethan als Lösungsmittel, wobei eine Konzentration in einem Bereich von 100g zerkleinertem Wachsmantel auf einen Liter Lösungsmittel eingestellt wird, und eine Standzeit der Lösung von 1 Woche bei Raumtemperatur.

15. Verfahren nach einem der Ansprüche 12 bis 14,
**gekennzeichnet durch**
ein Beimischen von abriebfesten Nanopartikeln und/oder im Infrarotbereich reflektierenden Nanopartikeln und/oder biozid wirkenden Nanopartikeln als lichtinaktive Additive in die Wachsmischung oder Auftragen aus einer Kolloidlösung.

16. Verfahren nach einem der Ansprüche 12 bis 15,
**gekennzeichnet durch**
ein Beimischen oder Auftragen von Barrierematerial.

17. Verfahren nach Anspruch 15 oder 16,
**gekennzeichnet durch**
ein alternierendes Auftragen von Schichten aus dem Versiegelungsmaterial und aus Nanopartikeln und/oder aus Barrierematerial.

18. Verfahren nach einem der Ansprüche 12 bis 17,
**gekennzeichnet durch**
ein alternierendes Auftragen von Schichten aus einem Barrierematerial.

19. Verfahren nach einem der Ansprüche 12 bis 18,
**gekennzeichnet durch**
zyklisches Eintauchen einer zu versiegelnden technischen Oberfläche in die abfiltrierte Wachslösung als Tauchlösung bei Raumtemperatur und Aushärten der einzelnen wachsbasierten Versiegelungsschichten **durch** Entfernen des Lösungsmittels bis zur Erreichung einer vorgegebenen Gesamtschichtstärke.

20. Verfahren nach einem der Ansprüche 12 bis 19,
**gekennzeichnet durch**
einen abschließenden Mikrostrukturierungsvorgang der Oberfläche der fertiggestellten Schicht aus dem Versiegelungsmaterial.

21. Anwendung eines transparenten Versiegelungsmaterial für starker Lichteinstrahlung ausgesetzte, photoelektronisch aktive Oberflächen mit einer chemischen Zusammensetzung aus einem langkettigen natürlichen Wachs oder einer Wachsmischung mit einem oberhalb 70°C beginnenden Schmelztemperaturbereich als transparente organische Basiskomponente und zumindest einem Antioxidanzium, einem Reduktionsmittel und einem Biozid als Additive zur Verbesserung der Langzeitstabilität des Versiegelungsmaterials, insbesondere nach einem der Ansprüche 1 bis 11, in einer Ausbildung als Deckschicht oder als Zwischenschicht unter einer Abdeckscheibe in einem Photovoltaikelement.

22. Anwendung eines transparenten Versiegelungsmaterials nach Anspruch 21 in einer Ausbildung als vollständige Einkapselung eines Photovoltaikmoduls.

## Claims

1. Transparent sealing material for light-irradiated, photoelectronically active surfaces with a chemical composition consisting of a transparent, organic base component and a plurality of added additives to improve the long-term stability of the sealing material, **characterised in that** the transparent organic base component is a long-chain, natural wax or a wax mixture with a melting-temperature range starting above 70°C, to which at least an antioxidant, a reducing agent and a biocide are added as additives.

2. Transparent sealing material according to claim 1, **characterised by** a proportion by weight of the natural wax or of the wax mixture in the range of 60%, of the antioxidant in the range of 20%, of the reducing agent in the range of 10% and of the biocide in the range of 10% in the chemical composition.

3. Transparent sealing material according to claim 1 or 2, **characterised by** a variable chain length of the natural wax or of the wax mixture in the range of 22 to 36 carbon atoms.

4. Transparent sealing material according to one of claims 1 to 3, **characterised by** a proportion by weight in the range of 40% of esters of long-chain, aliphatic alcohols and acids and in the range of 20% of oligoesters with two or more ester functions as components of the wax or of the wax mixture in the chemical composition.

5. Transparent sealing material according to one of claims 1 to 4, **characterised by** a proportion by weight in the range of up to 5% of aromatic acids and esters and in the range between 1% and 20% of aliphatic acids as individual or combined components of the antioxidant in the chemical composition.

6. Transparent sealing material according to one of claims 1 to 5, **characterised by** an alcohol as a reducing agent, with its proportion by weight in the chemical composition lying in a range between 5% and 15%.

7. Transparent sealing material according to one of claims 1 to 6, **characterised by** a proportion by weight in a range between 1% and 10% of terpenes as a biocide in the chemical composition.

8. Transparent sealing material according to one of claims 1 to 7, **characterised by** an admixture or an application of nanoparticles that are abrasion-resistant and/or nanoparticles that are reflective in the infrared range and/or nanoparticles that act biocidally as light-inactive additives in the chemical composition.

9. Transparent sealing material according to one of claims 1 to 8, **characterised by** an admixture or an application of barrier material.

10. Transparent sealing material according to claim 8 or 9, **characterised by** an alternating layer structure consisting of a plurality of layers of sealing material and nanoparticles and/or barrier material.

11. Transparent sealing material according to one of claims 1 to 10, **characterised by** a mechanically, chemically, electrically or optically generated microstructuring in the surface.

12. Method for the production and use of a transparent sealing material for photoelectronically active surfaces, which are exposed to strong light-irradiation, of a chemical bringing-together of a long-chain, natural wax or of a wax mixture with a melting-temperature range starting above 70°C as a transparent organic base component with at least an antioxidant, a reducing agent and a biocide as additives to improve the long-term stability of the sealing material, in particular according to one of claims 1 to 7, wherein the natural wax or the wax mixture is obtained by dissolving the comminuted wax casing of special plants having a wax casing in a solvent and filtering off the dissolved wax after a predetermined standing time.

13. Method according to claim 12, **characterised by** the use of *Sarcocaulon patersonii* or *Euphorbia cerifera* as plants for the obtainment of wax.

14. Method according to claim 12 or 13, **characterised by** the use of dichloromethane as a solvent, with a concentration being adjusted in a range of 100g comminuted wax casing to a litre of solvent, and a standing time of the solution of 1 week at room temperature.

15. Method according to one of claims 12 to 14, **characterised by** an admixture of nanoparticles that are abrasion-resistant and/or nanoparticles that are reflective in the infrared range and/or nanoparticles that act biocidally as light-inactive additives into the wax mixture or application from a colloidal solution.

16. Method according to one of claims 12 to 15, **characterised by** an admixture or application of barrier material.

17. Method according to claim 15 or 16, **characterised by** alternate application of layers of the sealing material and of nanoparticles and/or of,barrier material.

18. Method according to one of claims 12 to 17, **characterised by** alternate application of layers of a barrier material.

19. Method according to one of claims 12 to 18, **characterised by** cyclically dipping a technical surface that is to be sealed into the filtered-off wax solution as a dipping solution at room temperature and hardening the individual wax-based sealing layers by removing the solvent until a predetermined total layer thickness is achieved.

20. Method according to one of claims 12 to 19, **characterised by** a final process of microstructuring of the surface of the finished layer of the sealing material.

21. Use of a transparent sealing material for photoelectronically active surfaces that are exposed to strong light-irradiation with a chemical composition consisting of a long-chain, natural wax or of a wax mixture with a melting-temperature range starting above 70°C as a transparent organic base component and at least an antioxidant, a reducing agent and a biocide as additives to improve the long-term stability of the sealing material, in particular according to one of claims 1 to 11, in a formation as a cover layer or as an intermediate layer under a covering disc in a photovoltaic element.

22. Use of a transparent sealing material according to claim 21 in a formation as a complete encapsulation of a photovoltaic module.

## Revendications

1. Matériau d'étanchéité transparent pour des surfaces à activité photo-électronique exposées à la lumière, ayant une composition chimique formée d'un composant de base organique transparent et de plusieurs additifs pour améliorer la stabilité à long terme de la matière d'étanchéité,
**caractérisé en ce que**
le composant de base organique transparent est une cire naturelle à chaîne longue ou un mélange de cires ayant une plage de températures de fusion commençant au-dessus de 70°C, avec ajout d'au moins un antioxydant, d'un agent réducteur et d'un biocide.

2. Matériau d'étanchéité transparent selon la revendication 1,
**caractérisé par**
une teneur pondérale de cire naturelle ou d'un mélange de cires de l'ordre de 60 %, d'un antioxydant de l'ordre de 20 %, d'un agent réducteur de l'ordre de 10 % et d'un biocide de l'ordre de 10 % dans la composition chimique.

3. Matière d'étanchéité transparente selon la revendication 1 ou 2,
**caractérisée par**
une longueur de chaîne variable de la cire naturelle ou du mélange de cires dans une plage comprise entre 22 et 36 atomes de carbone.

4. Matière d'étanchéité transparente selon l'une des revendications 1 à 3,
**caractérisée par**
une teneur pondérale de l'ordre de 40 % pour des esters d'alcool aliphatique à chaîne longue et des acides et de l'ordre de 20 % d'oligo-esters à deux ou plusieurs fonctions esters comme composants de la cire ou du mélange de cires dans leur composition chimique.

5. Matière d'étanchéité transparente selon l'une des revendications 1 à 4,
**caractérisée par**
une teneur pondérale allant jusqu'à 5 % d'acides aromatiques et d'ester et dans une plage comprise entre 1 % et 20 % d'acides aliphatiques comme composants séparés ou combinés de l'antioxydant dans la composition chimique.

6. Matière d'étanchéité transparente selon l'une des revendications 1 à 5,
**caractérisée par**
un alcool comme agent réducteur, dont la teneur en poids dans la composition chimique se situe dans une plage comprise entre 5 % et 15 %.

7. Matière d'étanchéité transparente selon l'une des revendications 1 à 6,
**caractérisée par**
une teneur en poids dans une plage comprise entre 1 % et 10 % de terpènes comme biocides dans la composition chimique.

8. Matière d'étanchéité transparente selon l'une des revendications 1 à 7,
**caractérisée par**
un mélange ou une application de nanoparticules résistant à l'abrasion et/ou de nanoparticules réfléchissant dans le domaine infrarouge et/ou de nanoparticules à effet biocide comme additifs non photo-actifs dans la composition chimique.

9. Matière d'étanchéité transparente selon l'une des revendications 1 à 8,
**caractérisée par**
l'adjonction ou l'application d'une matière formant barrière.

10. Matière d'étanchéité transparente selon l'une des revendications 8 ou 9,
**caractérisée par**
une structure stratifiée alternée formée de plusieurs couches de matière d'étanchéité et de nanoparticules et/ou de matière formant une barrière.

11. Matière d'étanchéité transparente selon l'une des revendications 1 à 10,
**caractérisée par**
une microstructure mécanique, chimique, électrique ou optique, produite dans la surface supérieure.

12. Procédé de fabrication et d'application d'une matière d'étanchéité transparente pour des surfaces à activité photo-électronique exposées à un intense rayonnement lumineux, pour une composition chimique de cire naturelle à chaîne longue ou d'un mélange de cires ayant une plage de températures de fusion commençant au-dessus de 70°C, comme composant de base organique transparent ayant au moins un antioxydant, un agent réducteur et un biocide comme additif pour améliorer la stabilité à long terme de la matière d'étanchéité, notamment selon l'une des revendications 1 à 7, la cire naturelle ou le mélange de cires étant obtenu par dissolution de l'enveloppe de cire, réduite en petits morceaux de plantes spéciales ayant une enveloppe de cire dans laquelle on récupère la cire lavée après un temps de séjour prédéfini dans un solvant et par filtrage.

13. Procédé selon la revendication 12,
**caractérisé par**
l'utilisation de *Sarcocaulon Patersinii* ou *Euphorbia Cerifera* comme plantes pour récupérer la cire.

14. Procédé selon la revendication 12 ou la revendication 13,
**caractérisé par**
l'utilisation de dichlorométhane comme solvant, la concentration se situant dans une plage de 100 g d'enveloppe de cire réduite en morceaux par litre de solvant et le temps de séjour de la solution est de 1 semaine à la température ambiante.

15. Procédé selon l'une des revendications 12 à 14,
**caractérisé en ce qu'**
on mélange des nanoparticules résistant à l'abrasion et/ou des nanoparticules réfléchissant dans le domaine de l'infrarouge et/ou des nanoparticules à effet biocide comme additifs à activité lumineuse dans le mélange de cires ou application d'une solution colloïdale.

16. Procédé selon l'une des revendications 12 à 15,
**caractérisé en ce qu'**
on ajoute et on applique de la matière formant barrière.

17. Procédé selon l'une des revendications 15 ou 16,
**caractérisé par**
une application alternée de couches de matière de scellement et de nanoparticules et/ou de matières formant barrière.

18. Procédé selon l'une des revendications 12 à 17,
**caractérisé par**
une application alternée de couches formées d'une matière constituant une barrière.

19. Procédé selon l'une des revendications 12 à 18,
**caractérisé par**
une immersion cyclique d'une surface technique à rendre étanche dans la solution de lavage, séparée par filtrage comme solution d'immersion à la température ambiante et prise des différentes couches de scellement à base de cire par enlèvement du solvant jusqu'à atteindre une épaisseur de couche globale prédéfinie.

20. Procédé selon l'une des revendications 12 à 19,
**caractérisé par**
une opération de mise en microstructure, finale de la surface de la couche terminée à partir de la matière d'étanchéité.

21. Application d'une matière d'étanchéité transparente pour des surfaces à activité photo-électronique exposées à un rayonnement lumineux intense, ayant une composition chimique formée d'une cire naturelle à chaîne longue ou d'un mélange de cires ayant une plage de température de fusion commençant au-dessus de 70°C comme composant de base organique transparent et au moins un antioxydant, un agent réducteur et un biocide comme additifs pour améliorer la stabilité à long terme de la matière d'étanchéité, notamment selon l'une des revendications 1 à 11 dans une réalisation comme couche de couverture ou comme couche intermédiaire sous un disque de couverture dans un élément photovoltaïque.

22. Application d'une matière d'étanchéité transparente selon la revendication 21, dans une réalisation comme moyen d'encapsulage complet d'un module photovoltaïque.
